Europäisches Patentamt

European Patent Office

Office européen des brevets

(19)

(11) Veröffentlichungsnummer: **0 024 027**
**A1**

(12) **EUROPÄISCHE PATENTANMELDUNG**

(21) Anmeldenummer: **80104599.8**

(22) Anmeldetag: **04.08.80**

(51) Int. Cl.³: **H 03 K 17/62**
**H 03 K 17/60**

(30) Priorität: **10.08.79 DE 2932587**

(43) Veröffentlichungstag der Anmeldung:
**18.02.81 Patentblatt 81/7**

(84) Benannte Vertragsstaaten:
**AT BE CH DE FR GB IT LI NL SE**

(71) Anmelder: **SIEMENS AKTIENGESELLSCHAFT Berlin**
**und München**
**Postfach 22 02 61**
**D-8000 München 22(DE)**

(72) Erfinder: **Bauch, Helmut, Dr.**
**Waldstrasse 3a**
**D-8130 Starnberg(DE)**

(72) Erfinder: **Rehm, Hans, Dipl.-Ing.**
**Wildenfelserstrasse 19**
**D-8000 München 60(DE)**

(54) **Breitbandkoppelanordnung in ECL-Technik.**

(57) Die Koppelpunktschalter dir Koppselanordnung sind jeweils durch eine Differenzverstärkerschaltung mit zwei emitterkoppelten Hochfrequenztransistoren (T1, T2) gebildet; zur Herabsetzung des Leistungsverbrauchs ist im gemeinsamen Emitterstromkreis ein Schalttransistor (T3) eingefügt, der nur dann leitend ist, wenn der betreffende Koppelpunkt in den Durchschaltezustand gesteuert ist. Die Erfindung kann insbesondere bei der Verteilung von Videosignälen Anwendung finden.

FIG 2

EP 0 024 027 A1

Croydon Printing Company Ltd.

Siemens Aktiengesellschaft          Unser Zeichen
Berlin und München                  VPA
                                    79 P 7 8 0 8 EUR

Breitbandkoppelanordnung

Die Erfindung bezieht sich auf eine Koppelanordnung zum wahlweisen Durchschalten von Signalen hoher Bandbreite, die insbesondere bei der Verteilung von Videosignalen Anwendung finden kann.

In einer solchen Breitband-Koppelanordnung können die Koppelpunktschaltkreise, deren Funktion es ist, Eingangsleitungen mit Ausgangsleitungen der Koppelanordnung wahlweise zu verbinden, im Hinblick auf möglichst kleine Schaltzeiten bzw. auf die durchzuschaltenden, vorzugsweise F-, PP- oder PC-modulierten Signale mit Signalfrequenzen von z.B. bis über 80 MHz durch in ECL-Technik realisierte Verknüpfungsglieder gebildet sein (s.Pfannschmidt: "Arbeitsgeschwindigkeitsgrenzen von Koppelnetzwerken für Breitband-Digitalsignale", Diss. TU Bswg.1978; DE-AS 28 28 662). Solche handelsüblichen Verknüpfungsglieder verursachen allerdings unabhängig von ihrem

Spr 1 Kel /31.7.1979

jeweiligen Schaltzustand Verlustleistungen, so daß größere Koppelfelder einen relativ hohen, größtenteils nutzlosen Leistungsverbrauch (s.auch Harthmuth, Duck, Jenik: "Aufbau und Anwendung integrierter Halbleiterschaltungen", Regelungstechnik 16(1968)12, 541...588, und 17(1969)1, 12...18; Abschn.3c) aufweisen.

Die Erfindung stellt sich nun die Aufgabe, einen solchen unnötigen Leistungsverbrauch zu vermeiden. Die Erfindung betrifft eine Breitband-Koppelanordnung mit Koppelpunkt-schaltkreisen in ECL-Technik; diese Koppelanordnung ist erfindungsgemäß dadurch gekennzeichnet, daß die Koppelpunktschalter lediglich mit nur im Durchschaltezustand des jeweiligen Koppelpunktschalters leitenden Transistoren aufgebaut sind.

Die Erfindung bringt neben den Vorteilen einer beträcht-lichen Leistungseinsparung und damit geringerger Betriebs-kosten sowie geringerer Anforderungen an die Stromversorgungseinrichtungen eine Reihe weiterer Vorteile mit sich: So erlaubt die geringe Verlustwärme einen kompakten Aufbau, wobei Kühlungsmaßnahmen ganz entfallen oder zumindest wesentlich reduziert sein können; bei einer Integration kann ggf. eine entsprechend große Anzahl von Koppelpunktschaltkreisen auf einem Baustein (Chip) zusammengefaßt werden. In einer größeren Koppelanordnung, in der die Anzahl der jeweils durchgeschalteten Koppelpunktschalter klein gegenüber der Gesamtzahl der Koppelpunktschalter ist, haben die Koppelpunktschalter eine entsprechend niedrige mittlere Betriebszeit und damit eine entsprechend lange Lebensdauer bzw. eine entsprechend reduzierte Ausfallrate; nachdem die jeweils im Sperrzustand befindlichen, stromlosen Koppelpunktschalt-kreise keine Signalverstärkung bewirken, wird in der Koppelanordnung zugleich eine größere Übersprechdämpfung
erzielt und ein geringeres Rauschen erhalten.

Es sei an dieser Stelle bemerkt, daß es (z.B. aus
DE-OS 14 99 328) bekannt ist, in einer Schaltungsanordnung
zum Erzeugen eines dem Produkt zweier Eingangssignale
proportionalen elektrischen Ausgangssignals einen Transistor
im Emitterstromzweig zweier emittergekoppelter weiterer
Transistoren vorzusehen; Probleme einer wahlweisen Durchschaltung von Breitbandsignalen durch eine Koppelanordnung
und des Leistungsverbrauches einer solchen Breitbandkoppelanordnung werden dabei indessen nicht berührt.

In weiterer Ausgestaltung der Erfindung können die
Koppelpunktschalter jeweils durch eine Differenzverstärkerschaltung mit zwei emittergekoppelten HF-Transistoren
und einem im gemeinsamen Emitterstromzweig eingefügten,
nur bei Ansteuerung des betreffenden Koppelpunktschalters
leitenden Schalttransistor gebildet sein, wobei einer der
HF-Transistoren mit seiner Basis an eine Eingangsleitung
der Koppelanordnung angeschlossen ist und an den Kollektor
eines der HF-Transistoren eine Ausgangsleitung der Koppelanordnung angeschlossen ist; dabei kann der eine HF-Transistor mit seiner Basis an die jeweilige Eingangsleitung
und mit seinem Kollektor an eine Bezugspotentialquelle
(Masse) angeschlossen sein, während an den Kollektor des
anderen HF-Transistors, dessen Basis an einem Betriebsspannungsteiler liegt, die jeweilige Ausgangsleitung
angeschlossen ist. Eine solche Kopelanordnung, in der
ein Koppelpunktschalter (einschließlich Last) im Durchschaltezustand einen Leistungsverbrauch von ca. 40 bis
50 mW und im Sperrzustand einen praktisch gegen Null
gehenden Leistungsverbrauch aufweisen kann, eignet sich bei Verwendung entsprechend schneller HF-Transistoren zum Durchschalten von Signalen von bis über 600 Mbit/s.

In weiterer Ausgestaltung können einerseits die Basiselektroden der genannten jeweils einen HF-Transistoren einer ganzen Zeile von Differenzverstärkerschaltungen untereinander vielfach geschaltet an die betreffende Eingangsleitung angeschlossen sein, um so eine wahlweise Durchschaltung der betreffenden Eingangsleitung zu einer von mehreren Ausgangsleitungen zu ermöglichen; andererseits können die Kollektoren der jeweils anderen HF-Transistoren einer ganzen Spalte von Differenzverstärkerschaltungen untereinander vielfach geschaltet an die betreffende Ausgangsleitung angeschlossen sein, um so eine wahlweise Durchschaltung einer von mehreren Eingangsleitungen zu dieser Ausgangsleitung zu ermöglichen.

In weiterer Ausgestaltung der Erfindung können die einen Hauptelektroden der Schalttransistoren einer Spalte von Differenzverstärkerschaltungen, bei denen die Kollektoren der einen HF-Transistoren untereinander vielfach geschaltet an die betreffende Ausgangsleitung angeschlossen sind, untereinander vielfach geschaltet an eine Betriebspotentialquelle angeschlossen sein. Die Steuerelektroden der Schalttransistoren können in weiterer Ausgestaltung mit den einzelnen Ausgängen eines der Koppelanordnung zugeordneten Ansteuerdecoders verbunden sein.

Anhand der Zeichnung sei die Erfindung noch näher erläutert. Dabei zeigt
Fig.1 ein Ausführungsbeispiel für einen Koppelpunktschalter gemäß der Erfindung;

Fig.2 zeigt eine mit Koppelpunktschaltern nach Fig.1 aufgebaute Koppelmatrix.

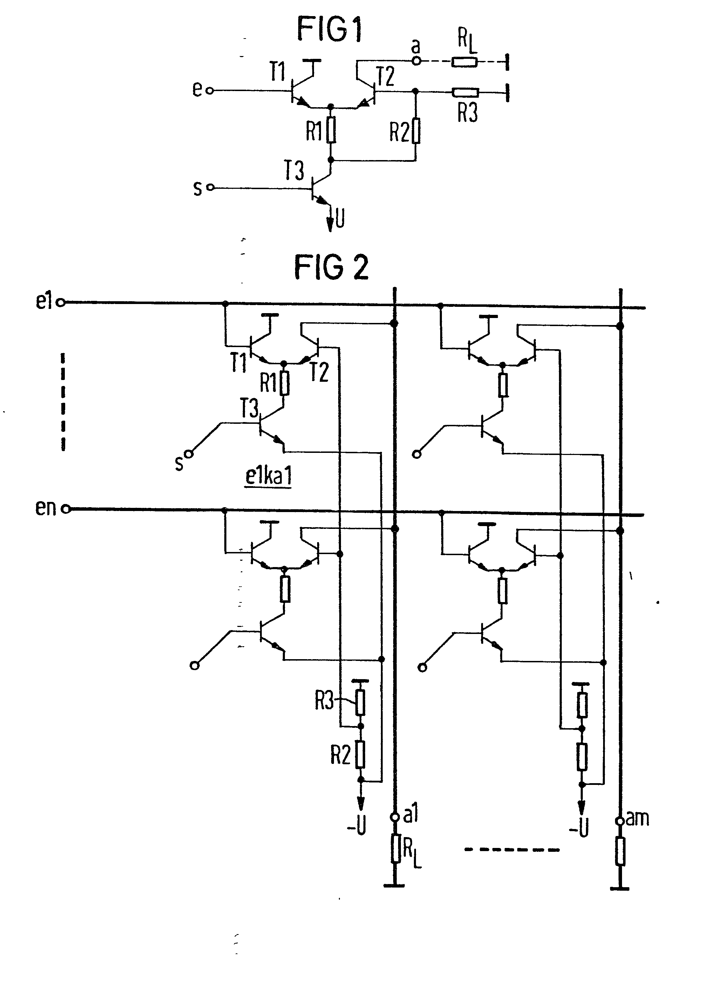

In der Zeichnung Fig.1 ist eine Breitbandkoppelanordnung mit einem Koppelpunktschalter in ECL-Technik dargestellt, der im wesentlichen aus einer Differenzverstärkerschaltung mit zwei emittergekoppelten HF-Transistoren T1, T2 und einem zusammen mit einem Widerstand R1 in den gemeinsamen Emitterstromkreis eingefügten Schalttransistor T3 gebildet ist, dessen den HF-Transistoren abgewandte Hauptelektrode an der eine Betriebsspannung von beispielsweise –5V aufweisenden Betriebsspannungsquelle U liegt. Der eine HF-Transistor T1 ist mit seiner Basis an eine Eingangsleitung e der Koppelanordnung angeschlossen und liegt mit seinem Kollektor an einer Bezugspotentialquelle (Masse); an den Kollektor des anderen HF-Transistors T2, dessen Basis an einem Betriebsspannungsteiler Masse-R3-R2-U liegt, ist eine Ausgangsleitung a der Koppelanordnung angeschlossen, wobei in der Zeichnung Fig.1 angedeutet ist, daß diese Ausgangsleitung a mit einem Lastwiderstand $R_L$ belastet sein kann. Der Schalttransistor T3 liegt mit seiner Basis an der Ansteuerleitung s des Koppelpunktschalters, so daß er nur bei dessen Ansteuerung leitend ist.

Bei einer solchen Ansteuerung über die Ansteuerleitung s, die mit TTL-Signalpegel geschehen kann, befindet sich der in Fig.1 dargestellte Koppelpunktschalter im Durchschaltezustand und bietet damit einen schnellen Signalpfad zwischen der Eingangsleitung e und der Ausgangsleitung a, über den zumindest bei diskretem Aufbau mit entsprechend schnellen HF-Transistoren T1 und T2 Signale bis über 600 Mbit/s durchgeschaltet werden können; dabei ist von Vorteil, daß der Ansteuerkreis seinerseits durchaus nicht für so hochfrequente bzw. breitbandige Signale ausgelegt zu werden braucht, da er solchen Signalen nicht folgen muß, sondern lediglich beim Aufbau einer Verbindung zwischen Eingangsleitung e und Ausgangsleitung a die Durchschaltung des Koppelpunktschalters und beim Auslösen der Verbindung die Sperrung des Koppelpunktschalters bewirkt und während des Durchschaltezustandes lediglich den praktisch konstanten Summenstrom beider HF-Transistoren T1, T2 führt. Der Leistungsverbrauch des Koppelpunktschalters liegt im Durchschaltezustand bei ca.40...50 mW.

Wird der Koppelpunktschalter nicht angesteuert, sind der Schalttransistor T3 und damit - wegen der Nichtzuführung der Betriebsspannung U von beispielsweise -5V - auch die HF-Transistoren T1, T2 nichtleitend. Der Koppelpunktschalter befindet sich damit im Sperrzustand; der Leistungsverbrauch geht praktisch gegen 0 mW.

Die Zeichnung Fig.2 zeigt schematisch in einem zum Verständnis der Erfindung erforderlichen Umfange eine mit Koppelpunktschaltern nach Fig.1 aufgebaute Breitbandkoppelmatrix mit einer Mehrzahl von Eingangsleitungen e1...en und einer Mehrzahl von Ausgangsleitungen a1...am. Im Kreuzungspunkt jeweils einer Eingangsleitung und einer Ausgangsleitung liegt ein Koppelpunktschalter; so liegt im Kreuzungspunkt der Eingangsleitung e1 und der Ausgangsleitung a1 der Koppelpunktschalter e1ka1.

Dieser Koppelpunktschalter ist prinzipiell in der aus Fig.1 ersichtlichen Weise aufgebaut, enthält also wiederum eine Differenzverstärkerschaltung mit zwei emittergekoppelten HF-Transistoren T1, T2 und einen in Serie zum gemeinsamen Emitterwiderstand R1 liegenden, nur bei Ansteuerung des betreffenden Koppelpunktschalters (e1ka1) leitenden Schalttransistor T3, dessen Basis dazu an die Ansteuerleitung s des Koppelpunktschalters e1ka1 angeschlossen ist. Jeder der Koppelpunktschalter der Breitbandkoppelmatrix nach Fig.2 weist eine solche ihm individuell zugehörige Ansteuerleitung auf, wie sie beim Koppelpunktschalter e1ka1 mit s bezeichnet ist; diese Ansteuerleitungen und damit die Steuerelektroden der einzelnen Schalttransistoren können, ohne daß dies in Fig.2 im einzelnen noch dargestellt wäre, mit den einzelnen Ausgängen eines der Koppelmatrix zugeordneten Ansteuerdecoders verbunden sein.

An die Eingangsleitung e1 der Koppelanordnung nach Fig.2 sind dabei die Basis-Elektroden der jeweils einen HF-Transistoren, wie des HF-Transistors T1 des Koppelpunktschalters e1ka1, einer ganzen Zeile von Differenzverstärkerschaltungen untereinander vielfach geschaltet angeschlossen; entsprechendes gilt auch für die weiteren Eingangsleitungen ...en der Breitbandkoppelanordnung nach Fig.2. Andererseits sind an die Ausgangsleitung a1 die Kollektoren der jeweils anderen HF-Transistoren, wie des HF-Transistors T2 des Koppelpunktschalters e1ka1, einer ganzen Spalte von Differenzverstärkerschaltungen untereinander vielfachgeschaltet angeschlossen. Die maximale Anzahl n der Koppelpunktschalter, deren Ausgänge man so durch "wired-or"-Verknüpfung an eine gemeinsame Ausgangsleitung a anschließen kann, hängt von den HF-Transistor-Eigenschaften sowie der Höhe der Frequenzen der zu übertragenden Signale ab. So können bei Verwendung von beispielsweise durch Transistoren BFS20 gegebenen diskreten HF-Transistoren über eine etwa n = 20 Eingangsleitungen e aufweisende Breitbandkoppelanordnung nach Fig.2 Signale mit Signalfrequenzen bis in der Größenordnung von 100 MHz durchgeschaltet werden. Es sei in diesem Zusammenhang aber besonders bemerkt, daß die Erfindung nicht auf eine Realisierung der Breitbandkoppelanordnung mit diskreten Bauelementen beschränkt ist, sondern gerade auch für eine monolithischintegrierte Lösung prädestiniert ist.

Wird ein Koppelpunktschalter, beispielsweise der Koppelpunktschalter e1ka1, über die ihm individuell zugehörige Ansteuerleitung s angesteuert, so wird der Schalttransistor T3 des Koppelpunktschalters leitend, so daß das Betriebspotential U von beispielsweise -5V an den Emitterzweig der beiden HF-Transistoren T1, T2 des Koppelpunktschalters e1ka1 angeschaltet wird. In Fig.2 ist dazu angedeutet, daß die Emitter der Schalttransistoren (T3) einer Spalte von Koppelpunktschaltern (e1ka1) untereinander vielfachgeschaltet an eine Betriebspotentialquelle U angeschlossen sind, von der zugleich über einen Spannungsteiler R2, R3 das Steuerpotential für den jeweils zweiten HF-Transistor (T2) abgegriffen wird. Die beiden HF-Transistoren T1, T2 des betreffenden Koppelpunktschalters e1ka1 können damit in den Leitfähigkeitszustand gelangen, womit sich der betreffende Koppelpunktschalter im Durchschaltezustand befindet, in welchem er einen schnellen Signalpfad zwischen der zugehörigen Eingangsleitung (e1) und der zugehörigen Ausgangsleitung (a1) bietet. Der Ansteuerkreis selbst kann dabei wiederum für wesentlich langsamere Signale ausgelegt sein, da er während des Durchschaltezustandes des Koppelpunktschalters e1ka1 lediglich den praktisch konstanten Summenstrom der beiden HF-Transistoren T1, T2 führt.

Die Ansteuerung eines Koppelpunktschalters, wie beispielsweise des Koppelpunktschalters e1ka1, läßt die nicht angesteuerten Koppelpunktschalter der Breitband-koppelanordnung nach Fig.2 unbeeinflußt, unabhängig davon, ob diese Koppelpunktschalter an der gleichen
Eingangsleitung (e1) oder Ausgangsleitung (a1) wie der
gerade betrachtete Koppelpunktschalter e1ka1 liegen
oder nicht; sofern solche Koppelpunktschalter nicht
gerade selbst über ihre individuelle Ansteuerleitung
angesteuert sind, sind ihre Transistoren T1, T2, T3
stromlos und sind damit die Koppelpunktschalter
praktisch verlustleistungsfrei.

Patentansprüche

1. Breitbandkoppelanordnung mit Koppelpunktschaltkreisen in ECL-Technik, dadurch gekennzeichnet,
daß die Koppelpunktschalter (eKa) lediglich mit nur
im Durchschaltezustand des jeweiligen Koppelpunktschalters (e1ka1) leitenden Transistoren (T1, T2, T3)
aufgebaut sind.

2. Breitbandkoppelanordnung nach Anspruch 1, dadurch
gekennzeichnet, daß die Koppelpunktschalter (e1ka1)
jeweils durch eine Differenzverstärkerschaltung mit
zwei emittergekoppelten HF-Transistoren (T1, T2) und
einem im gemeinsamen Emitterstromzweig eingefügten,
nur bei Ansteuerung des betreffenden Koppelpunktschalters
(e1ka1) leitenden Schalttransistor (T3) gebildet sind,
wobei einer der HF-Transistoren (T1) mit seiner Basis
an eine Eingangsleitung (e) der Koppelanordnung angeschlossen ist und an den Kollektor eines der HF-Transistoren (T2) eine Ausgangsleitung (a) der Koppelanordnung
angeschlossen ist.

3. Breitbandkoppelanordnung nach Anspruch 2, dadurch
gekennzeichnet, daß der eine HF-Transistor (T1) mit
seiner Basis an die jeweilige Eingangsleitung (e)
und mit seinem Kollektor an eine Bezugspotentialquelle
(Masse) angeschlossen ist und an den Kollektor des
anderen HF-Transistors (T2), dessen Basis an einem
Betriebsspannungsteiler (Masse-R3-R4-U) liegt, die
jeweilige Ausgangsleitung (a) angeschlossen ist.

4. Breitbandkoppelanordnung nach einem der Ansprüche 2 bis 3, dadurch gekennzeichnet, daß die Basiselektroden der jeweils einen HF-Transistoren (T1) einer ganzen Zeile von Differenzverstärkerschaltungen untereinander vielfachgeschaltet an die betreffende Eingangsleitung (e) der Koppelanordnung angeschlossen sind.

5. Breitbandkoppelanordnung nach einem der Ansprüche 2 bis 4, dadurch gekennzeichnet, daß die Kollektoren der jeweils anderen HF-Transistoren (T2) einer ganzen Spalte von Differenzverstärkerschaltungen untereinander vielfachgeschaltet an die betreffende Ausgangsleitung (a) der Koppelanordnung angeschlossen sind.

6. Breitbandkoppelanordnung nach Anspruch 5, dadurch gekennzeichnet, daß die einen Hauptelektroden (Emitter) der Schalttransistoren (T3) einer Spalte von Differenzverstärkerschaltungen (e1ka1) untereinander vielfachgeschaltet an eine Betriebspotentialquelle (U) angeschlossen sind.

7. Breitbandkoppelanordnung nach einem der Ansprüche 2 bis 6, dadurch gekennzeichnet, daß die Steuerelektroden der Schalttransistoren (T3) mit den einzelnen Ausgängen eines der Koppelanordnung zugeordneten Ansteuerdecoders verbunden sind.

## FIG 1

## FIG 2

**0024027**

Europäisches Patentamt

**EUROPÄISCHER RECHERCHENBERICHT**

Nummer der Anmeldung
EP 80 10 4599

## EINSCHLÄGIGE DOKUMENTE

| Kategorie | Kennzeichnung des Dokuments mit Angabe, soweit erforderlich, der maßgeblichen Teile | betrifft Anspruch |
|---|---|---|
| X | US - A - 3 838 296 (McLEOD)<br>* Von Spalte 2, Zeile 45 bis Spalte 4, Zeile 60; Figur 3B * | 1-3, 5-7 |
| | -- | |
| | FR - A - 2 386 224 (WESTERN ELEC-TRIC)<br>* Von Seite 2, Zeile 29 bis Seite 3, Zeile 34; Figuren 1,2 * | 4-6 |
| | -- | |
| DA | DE - A - 1 499 328 (NORTHERN ELECTRIC) | 1 |
| | ---- | |

**KLASSIFIKATION DER ANMELDUNG (Int. Cl.³)**

H 03 K 17/62
H 03 K 17/60

**RECHERCHIERTE SACHGEBIETE (Int Cl.³)**

H 03 K 17/62
17/60

**KATEGORIE DER GENANNTEN DOKUMENTE**

X: von besonderer Bedeutung
A: technologischer Hintergrund
O: nichtschriftliche Offenbarung
P: Zwischenliteratur
T: der Erfindung zugrunde liegende Theorien oder Grundsätze
E: kollidierende Anmeldung
D: in der Anmeldung angeführtes Dokument
L: aus andern Gründen angeführtes Dokument
&: Mitglied der gleichen Patent-familie, übereinstimmendes Dokument

Der vorliegende Recherchenbericht wurde für alle Patentansprüche erstellt.

| Recherchenort | Abschlußdatum der Recherche | Prüfer |
|---|---|---|
| Den Haag | 14-11-1980 | CANTARELLI |

EPA form 1503.1 06.78